# EUROPÄISCHE PATENTSCHRIFT

(11) **EP 3 454 631 B1**
(45) Veröffentlichungstag und Bekanntmachung des Hinweises auf die Patenterteilung: **25.03.2020**
(21) Anmeldenummer: 17020414.3
(22) Anmeldetag: 08.09.2017
(51) Int. Cl.: H05K 3/00, H05K 1/02, H05K 3/28, H05K 3/40, G01N 21/84, G01N 21/3581, H05K 1/05, H05K 1/09, G01N 21/956

(54) **VERFAHREN ZUR HERSTELLUNG EINES ELEKTRISCHEN ANSCHLUSSKONTAKTS AN EINEM BESCHICHTETEN BLECH**
METHOD FOR THE PRODUCTION OF AN ELECTRIC CONNECTING CONTACT ON COATED SHEET METAL
PROCÉDÉ DE FABRICATION D'UNE BORNE ÉLECTRIQUE SUR UNE TÔLE REVÊTUE

(43) Veröffentlichungstag der Anmeldung: 13.03.2019
(73) Patentinhaber: voestalpine Stahl GmbH, 4020 Linz (AT)
(72) Erfinder: Braidt, Roland, 4202 Hellmonsödt (AT); Atzmüller, Peter, 4020 Linz (AT); Jakoby, Berhard, 4040 Linz (AT); Hilber, Wolfgang, 4293 Gutau (AT); Sell, Johannes, 4030 Linz (AT); Enser, Herbert, 4040 Linz (AT)
(74) Vertreter: Atzmüller, Peter

(56) Entgegenhaltungen:
- EP-A1- 0 466 226
- EP-A2- 0 669 792
- WO-A1-2009/115796
- WO-A1-2014/127856
- WO-A1-2014/195943
- US-A1- 2004 118 824
- US-A1- 2006 223 236

## Beschreibung

Die Erfindung betrifft ein Verfahren zur Herstellung eines elektrischen Anschlusskontakts an einem beschichteten Blech, dessen Beschichtung mindestens eine von einer elektrischen Isolationsschicht abgedeckte elektrische Leiterbahn aufweist, bei welchem Verfahren ein Werkzeug relativ zur elektrischen Leiterbahn positioniert, nachfolgend mit Hilfe des Werkzeugs eine Ausnehmung durch die elektrische Isolationsschicht bis zumindest zur elektrischen Leiterbahn hin erzeugt wird und in einem nächsten Schritt in diese Ausnehmung ein elektrisch leitendes Kontaktelement vorgesehen wird, welches elektrisch an einem seiner Enden an die Leiterbahn anschließt und an einem anderen seiner Enden den elektrischen Anschlusskontakt ausbildet.

Um eine Leiterbahn, die in einer Beschichtung auf einem Metallblech eingebettet ist, elektrisch anschließen zu können, ist es aus dem Stand der Technik bekannt (EP1517597A2), mit Hilfe eines Werkzeugs die Isolationsschicht bereichsweise zu entfernen, um eine Ausnehmung zum Vorsehen eines elektrisch leitenden Kontaktelements zu schaffen. Die Positionierung des Werkzeugs erfolgt über die vom Metallblech bekannten Daten zum Verlauf der abgedeckten Leiterbahn. Nachteilig führen gegenüber der Leiterbahn ungenau positionierte Ausnehmungen zu erhöhten elektrischen Widerstandswerten am Anschlusskontakt. Die Reproduzierbarkeit des Verfahren ist demnach gering - auch die Funktion einer derart hergestellten Vorrichtung ist beeinträchtigt. Mit einer relativ aufwändigen Erhöhung der Genauigkeit des Verfahrens kann die Reproduzierbarkeit des Verfahrens zwar verbessert werden - Parameterschwankungen in der Herstellung des Blechs - womit Daten zum Verlauf der abgedeckten Leiterbahn abweichen - stellen für das Verfahren zur Herstellung eines elektrischen Anschlusskontakts weiterhin eine hohe Unsicherheit in Bezug auf deren Reproduzierbarkeit dar. Der Stand der Technik gemäß dem Oberbegriff von Anspruch 1 ist im Dokument US-A1-2006223236 offenbart.

Es ist daher die Aufgabe der Erfindung, ein Verfahren zur Herstellung des elektrischen Anschlusskontakts in seiner Reproduzierbarkeit und Genauigkeit zu verbessern.

Die Erfindung löst die gestellte Aufgabe dadurch, dass das Blech mit einem Infrarotdetektor abgetastet, aus diesen Abtastdaten eine Wärmeverteilung des Blechs gebildet und anhand der Wärmeverteilung eine Ortsinformation zur Leiterbahn des Blechs bestimmt wird, welche Ortsinformation bei der Positionierung des Werkzeugs berücksichtigt wird.

Wird das Blech mit einem Infrarotdetektor abgetastet, aus diesen Abtastdaten eine Wärmeverteilung des Blechs gebildet und anhand der Wärmeverteilung eine Ortsinformation zur Leiterbahn des Blechs bestimmt, welche Ortsinformation bei der Positionierung des Werkzeugs berücksichtigt wird, kann das Verfahren in seiner Reproduzierbarkeit deutlich verbessert werden. Derart können nämlich die Daten der, vom Blech bekannten Ortsinformationen zur Leiterbahn mit den Ortsinformationen, generiert aus der Wärmeverteilung, verbessert werden. Auf diese Weise ist die Genauigkeit der Positionierung des Werkzeugs erhöhbar. Das erfindungsgemäße Verfahren ist sohin in der Ausbildung des Anschlusskontakts unempfindlicher gegenüber Prozessschwankungen in der Herstellung des beschichteten Blechs - was prozesssicher zu einem widerstandsarmen Anschlusskontakt führen kann. Selbstverständlich liegt es auch im Rahmen der Erfindung, dass zur Positionierung des Werkzeugs ausschließlich die anhand der Wärmeverteilung bestimmten Ortsinformation im Verfahren verwendet werden.

Die anhand der Wärmeverteilung bestimmte Ortsinformation kann weiter verbessert werden, wenn vor dem Abtasten des Blechs die Beschichtung impulsartig, insbesondere mit einem Blitz oder einem Heiz- oder Kühlgas, angeregt wird.

Wird über eine Zeitdauer hinweg die Wärmeverteilung erfasst und anhand der zeitlichen Veränderung der Wärmeverteilung auf eine Tiefeninformation der Leiterbahn in der Beschichtung rückgeschlossen, ist die Genauigkeit der Ortsinformation der Leiterbahn weiter erhöhbar.

Die Handhabbarkeit des Verfahrens kann erleichtert werden, wenn als Infrarotdetektor eine Thermographiekamera verwendet wird.

Wird die Ortsinformation zur Leiterbahn auf Grundlage des mittleren Infrarots (MIR) in der Wärmeverteilung des Blechs bestimmt, kann die Genauigkeit zur Ortsinformation der betreffenden Leiterbahn zusätzlich erhöht werden. Die die höhere Absorption von organischen Beschichtungen im MIR-Bereich kann nämlich den Signal-zu-Rausch Abstand weiter erhöhen, was die Genauigkeit des Verfahrens zur Herstellung eines elektrischen Anschlusskontakts weiter erhöhen kann. Im Allgemeinen wird erwähnt, dass das mittlere Infrarot MIR beispielsweise in einem Spektralbereich von 3 bis 50 µm Wellenlänge von elektromagnetischen Wellen liegen kann.

Die Ausnehmung durch die elektrische Isolationsschicht bis zumindest zur elektrischen Leiterbahn hin kann reproduzierbarer erzeugt werden, wenn diese mit Hilfe eines einen Laser oder eine Hohlnadel aufweisenden Werkzeugs erzeugt wird.

Aufgrund der exakten Positionierung des Werkzeugs kann es auch möglich werden, dass in die Ausnehmung eine elektrisch leitfähige, viskose Masse eingebracht wird, das Kontaktelement zu erzeugen. Dies kann das Verfahren erheblich vereinfachen und beispielsweise einen widerstandsarmen Kontakt sicherstellen. Als elektrisch leitfähige, viskose Masse ist beispielsweise eine elektrisch leitfähiges Polymer bzw. Paste/Tinte vorzugsweise geeignet.
Im Allgemeinen wird erwähnt, dass zur Ausbildung des Kontaktelements ein elektrisch leitfähiges Polymer, beispielsweise Polyanilin, Polypyrrol oder Polythiophen, verwendet werden kann. Solch eine Paste/Tinte kann stattdessen auch eine metallische Basis, wie beispielsweise Silber, Kupfer oder Gold, eine organische Basis, wie beispielsweise PEDOT ((Poly- 3,4-ethylendioxythiophene) oder eine Graphen-Basis aufweisen. Ebenso ist hierfür Carbon oder Graphit denkbar. Tinten/Pasten mit metallischer Basis können sich durch eine besonders günstige Leitfähigkeit auszeichnen, wohingegen Tinten und/oder Pasten mit organischer Basis zumeist eine erhöhte Korrosionsbeständigkeit bieten können. Eine Paste weist im Allgemeinen eine höhere Viskosität auf, beispielsweise > 50 mPa·s, bevorzugt > 1 Pa·s, als eine Tinte. Beispielsweise kann PEDOT:PSS als Tinte als auch als Paste hergestellt werden. Dies ist beispielsweise über die Menge an Lösungsmittel, wie beispielsweise Wasser oder Isopropanol, einstellbar.

In den Figuren ist beispielsweise der Erfindungsgegenstand anhand von Zeichnungen näher erläutert. Es zeigen
- Fig. 1: eine schematische Darstellung zur Erfassung von Ortsinformation zu einer Leiterbahn in einer Beschichtung auf einem Blech und
- Fig. 2: eine Seitenansicht auf ein beschichtetes Blech mit einem Werkzeug zum Einbringen einer Ausnehmung.

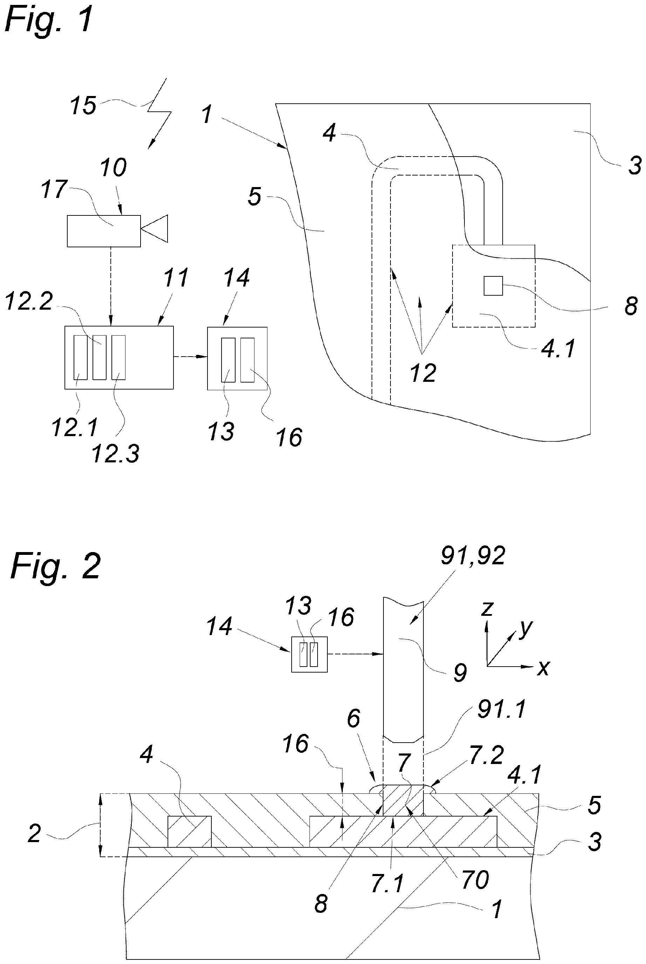

Nach der Figuren 1 und 2 wird ein Blech 1, vorzugsweise Feinblech, insbesondere aus einem Stahlwerkstoff, in einer teilweise aufgerissenen Draufsicht gezeigt, welches Blech 1 mit einer Beschichtung 2 versehen ist. Diese Beschichtung 2 besteht aus einer auf das Blech 1 aufgebrachten Grundierung 3, beispielsweise Primer, einer an der Grundierung vorgesehenen elektrische Leiterbahn 4 und einer elektrischen Isolationsschicht 5, beispielsweise ein Decklack, welcher die Leiterbahn 4 nach außen abdeckt.

Zudem ist in Fig. 2 ein eingezeichneter elektrischer Anschlusskontakt 6 zuerkennen, über welchen die Leiterbahn 4 elektrisch angeschlossen werden kann. Der elektrische Anschlusskontakt 6 wird von einem elektrisch leitenden Kontaktelement 7 ausgebildet. Wie in Zusammenschau mit Fig. 1 erkennbar, ragt das Kontaktelement 7 hierzu durch eine Ausnehmung 8 in der elektrischen Isolationsschicht 5 bis zur elektrischen Leiterbahn 4 und kontaktiert somit die Leiterbahn 4. Dadurch ist das Kontaktelement 7 an einem ersten Ende 7.1 mit der Leiterbahn 4 elektrisch verbunden, wobei das Kontaktelement 7 am anderen zweiten Ende 7.2 den elektrischen Anschlusskontakt 6 ausbildet.

Die Ausnehmung 8 wird mit Hilfe eines einen Laser 91 aufweisenden Werkzeugs 9 durch die elektrische Isolationsschicht 5 bis zumindest zur elektrischen Leiterbahn 4 hin erzeugt - beispielsweise durch die Materialablation des Laserstrahls 91.1 des Werkzeugs 9. Hierzu wird das Werkzeug 9 relativ zur elektrischen Leiterbahn 4 positioniert - beispielswiese direkt über der elektrischen Leiterbahn 4 -, und zwar an jener Stelle, an der die elektrischen Leiterbahn 4 ein Kontaktpad 4.1 ausbildet.

Nachdem Ausbildung der Ausnehmung 8 wird in diese eine elektrisch leitfähige viskose Masse 70, nämlich Paste, eingebracht, das feste Kontaktelement 7 zu erzeugen, beispielsweise durch weiteres Aushärten und/oder Trocknen, etc. der viskosen Masse 11.

Allgemeinen ist vorstellbar, dass anstatt eines Lasers 91 auch eine Hohlnadel 92 diese Ausnehmung 8 erzeugt. Eine Hohlnadel 92 bietet zudem den Vorteil, dass mit einem Zurückziehen der Hohlnadel 92 aus der erzeugten Ausnehmung 8 auch gleichzeitig die elektrisch leitfähige viskose Masse 70, nämlich die Paste, in diese Ausnehmung 8 eingebracht werden kann, das Kontaktelement 7 zu erzeugen, beispielsweise durch weiteres Aushärten und/oder Trocknen, etc. der viskosen Masse 11.

Um eine besonders genaue Positionierung des Werkzeugs 9 sicherzustellen, wird das Blech 1 erfindungsgemäß mit einem Infrarotdetektor 10 abgetastet, wie in Fig. 1 schematisch dargestellt. Diese Abtastdaten 12.1 des Infrarotdetektors 10 werden einer Recheneinheit 11 zugeführt, welche aus diesen Abtastdaten 12.1 eine Wärmeverteilung 12 des Blechs 1 bildet. Diese Wärmeverteilung 12 ist in Fig. 1 daran zu erkennen, dass die Leiterbahn 4 in einer Draufsicht durch die undurchsichtigen Isolationsschicht 5 zu erkennen ist, weil sich diese in der Wärmeabstrahlung von umgebenden Bereichen abhebt. Anhand dieser Wärmeverteilung 12 wird von der Recheneinheit 11 eine Ortsinformation 13 zur Leiterbahn 4 des Blechs 1 bestimmt und der Bewegungseinrichtung 14 übermittelt. Die Bewegungseinrichtung 14 positioniert in weiterer Folge das Werkzeug 9 anhand dieser Ortsinformation 13 entlang der beispielsweise dargestellten Bewegungsachsen x, y, z gegenüber dem Kontaktpad 4.1 mittig, was teilweise in der Fig. 2 zu erkennen ist. Damit kann die Herstellung einer exakt positionierten Ausnehmung 8 in der Isolationsschicht 5 sichergestellt werden. Ein in diese positionsgenaue Ausnehmung 8 eingebrachtes Kontaktelement 7 stellt sohin reproduzierbar eine widerstandsarme elektrische Kontaktierung her.

Vor der Abtastung des Blechs 1 durch den Infrarotdetektor 10 wird die Beschichtung impulsartig mit einem IR-Blitz 15 angeregt - wie dies in der Fig. 1 zu erkennen ist. Damit wird eine besonders gute Anregung des abzutastenden Blechs 1 für eine ausreichende Differenzierung der in der Wärmeverteilung 12 erkennbaren Elemente erreicht.

Zudem wird anhand der Wärmeverteilung die Tiefe 16 der Leiterbahn 4 in der Beschichtung 5 berechnet. Hierzu wird über eine Zeitdauer hinweg bzw. in einem Zeitintervall Δt die Wärmeverteilung 12 abgetastet - woraufhin mehrere Abtastdaten 12.1, 12.2, 12.3 in der Recheneinheit 11 gespeichert werden. Auf Grundlage der Abtastdaten 12.1, 12.2, 12.3 berechnet die Recheneinheit 11 eine zeitliche Veränderung der Wärmeverteilung 12, anhand welcher auf eine Tiefeninformation 16 der Leiterbahn 4 in der Beschichtung 2 rückgeschlossen wird. Diese Tiefeninformation 16 wird der Bewegungseinrichtung 14 übermittelt, um das Werkzeug 9 entsprechend der Eindringtiefe zu steuern/regeln.

Als Infrarotdetektor 10 wird in diesem Ausführungsbeispiel eine Thermographiekamera 17 verwendet.

Zudem wird die Ortsinformation 13 zur Leiterbahn 4 auf Grundlage des mittleren Infrarots (MIR) in der Wärmeverteilung 12 des Blechs 1 bestimmt, was aufgrund einer genauen Positionierung des Werkzeugs 9 ein besonders reproduzierbares Verfahren schafft.

## Patentansprüche

1. Verfahren zur Herstellung eines elektrischen Anschlusskontakts (6) an einem beschichteten Blech (1), dessen Beschichtung (2) mindestens eine von einer elektrischen Isolationsschicht (5) abgedeckte elektrische Leiterbahn (4) aufweist, bei welchem Verfahren
ein Werkzeug (9) relativ zur elektrischen Leiterbahn (4) positioniert,
nachfolgend mit Hilfe des Werkzeugs (9) eine Ausnehmung (8) durch die elektrische Isolationsschicht (5) bis zumindest zur elektrischen Leiterbahn (4) hin erzeugt wird und
in einem nächsten Schritt in diese Ausnehmung (8) ein elektrisch leitendes Kontaktelement (7) vorgesehen wird, welches elektrisch an einem seiner Enden (7.1) an die Leiterbahn (4) anschließt und an einem anderen seiner Enden (7.2) den elektrischen Anschlusskontakt (6) ausbildet,
**dadurch gekennzeichnet, dass**
das Blech (1) mit einem Infrarotdetektor (10) abgetastet, aus diesen Abtastdaten (12.1, 12.2, 12.3) eine Wärmeverteilung (12) des Blechs (1) gebildet und anhand der Wärmeverteilung (12) eine Ortsinformation (13) zur Leiterbahn (4) des Blechs (1) bestimmt wird, welche Ortsinformation (13) bei der Positionierung des Werkzeugs (9) berücksichtigt wird.

2. Verfahren nach Anspruch 1, **dadurch gekennzeichnet, dass** vor dem Abtasten des Blechs (1) die Beschichtung (2) impulsartig, insbesondere mit einem Blitz (15) oder einem Heiz- oder Kühlgas, angeregt wird.

3. Verfahren nach Anspruch 1 oder 2, **dadurch gekennzeichnet, dass** über eine Zeitdauer hinweg die Wärmeverteilung (12) erfasst und anhand der zeitlichen Veränderung der Wärmeverteilung (12) auf eine Tiefeninformation der Leiterbahn (4) in der Beschichtung (2) rückgeschlossen wird.

4. Verfahren nach Anspruch 1, 2 oder 3, **dadurch gekennzeichnet, dass** als Infrarotdetektor (10) eine Thermographiekamera (17) verwendet wird.

5. Verfahren nach einem der Ansprüche 1 bis 4, **dadurch gekennzeichnet, dass** die Ortsinformation (13) zur Leiterbahn (4) auf Grundlage des mittleren Infrarots (MIR) in der Wärmeverteilung (12) des Blechs (1) bestimmt wird.

6. Verfahren nach einem der Ansprüche 1 bis 5, **dadurch gekennzeichnet, dass** die Ausnehmung (8) mit Hilfe eines einen Laser (91) oder eine Hohlnadel (92) aufweisenden Werkzeugs (9) erzeugt wird.

7. Verfahren nach einem der Ansprüche 1 bis 6, **dadurch gekennzeichnet, dass** in die Ausnehmung (8) eine elektrisch leitfähige, viskose Masse (70), insbesondere Paste/Tinte, eingebracht wird, das Kontaktelement (7) zu erzeugen.

## Claims

1. Method for producing an electrical connecting contact (6) on a coated metal sheet (1), the coating (2) of which has at least one electrical conductor track (4) covered by an electrical insulation layer (5), In which method a tool (9) is positioned relative to the electrical conductor track (4), thereafter a recess (8) is produced with the aid of the tool (9) through the electrical insulation layer (5) at least as far as the electrical conductor track (4) and, in a next step, an electrically conductive contact element (7) is provided in this recess (8), which Is electrically connected at one of Its ends (7.1) to the conductor track (4) and forms the electrical connecting contact (6) at another of its ends (7.2), **characterized In that** the metal sheet (1) is scanned with an infrared detector (10), a heat distribution (12) of the metal sheet (1) is formed from this scanning data (12.1, 12.2, 12.3), and location information (13) with respect to the conductor track (4) of the metal sheet (1) Is determined by means of the heat distribution (12), which location Information (13) Is taken Into account when positioning the tool (9).

2. Method according to claim 1, **characterized in that** before the metal sheet (1) is scanned, the coating (2) is excited In a pulse-like manner, in particular with a flash (15) or a heating or cooling gas.

3. Method according to claim 1 or 2, **characterized In that** the heat distribution (12) is detected over a period of time and, on the basis of the change in the heat distribution (12) over time, a depth information of the conductor track (4) in the coating (2) is deduced.

4. Method according to claim 1, 2 or 3, **characterized In that** a thermography camera (17) is used as infrared detector (10).

5. Method according to one of claims 1 to 4, **characterized In that** the location Information (13) for the conductor track (4) is determined on the basis of the mean infrared (MIR) In the heat distribution (12) of the metal sheet (1).

6. Method according to one of claims 1 to 5, **characterized in that** the recess (8) is produced by means of a tool (9) comprising a laser (91) or a hollow needle (92).

7. Method according to one of claims 1 to 6, **characterized in that** an electrically conductive, viscous mass (70), in particular paste/Ink, is introduced into the recess (8) to produce the contact element (7).

## Revendications

1. Procédé de fabrication d'un contact de connexion électrique (6) sur une tôle (1) revêtue dont le revêtement (2) présente au moins une piste conductrice électrique (4) recouverte d'une couche d'isolation électrique (5), procédé dans lequel
un outil (9) est positionné par rapport à la piste conductrice électrique (4), ensuite, à l'aide de l'outil (9), un évidement (8) est réalisé à travers la couche d'isolation électrique (5) au moins jusqu'à la piste conductrice électrique (4), et dans une étape suivante, un élément de contact électriquement conducteur (7) est prévu dans cet évidement (8), lequel se raccorde électriquement à l'une de ses extrémités (7.1) à la piste conductrice (4) et forme le contact de connexion électrique (6) à une autre de ses extrémités (7.2),
**caractérisé en ce que**
la tôle (1) est balayée par un détecteur infrarouge (10), une répartition de chaleur (12) de la tôle (1) est formée à partir de ces données de balayage (12.1, 12.2, 12.3), et à l'aide de la répartition de chaleur (12), une information de localisation (13) relative à la piste conductrice (4) de la tôle (1) est déterminée, laquelle information de localisation (13) est prise en compte pour le positionnement de l'outil (9).

2. Procédé selon la revendication 1, **caractérisé en ce que**, avant le balayage de la tôle (1), le revêtement (2) est excité de manière puisée, en particulier avec un flash (15) ou un gaz de chauffage ou de refroidissement.

3. Procédé selon la revendication 1 ou 2, **caractérisé en ce que** la répartition de chaleur (12) est détectée sur une période de temps et l'information de profondeur de la piste conductrice (4) dans le revêtement (2) est déduite de la variation dans le temps de la répartition de chaleur (12).

4. Procédé selon la revendication 1, 2 ou 3, **caractérisé en ce qu'**une caméra thermographique (17) est utilisée comme détecteur infrarouge (10).

5. Procédé selon l'une des revendications 1 à 4, **caractérisé en ce que** l'information de localisation (13) relative à la piste conductrice (4) est déterminée sur la base de l'Infrarouge moyen (MIR) dans la répartition de chaleur (12) de la tôle (1).

6. Procédé selon l'une des revendications 1 à 5, **caractérisé en ce que** l'évidement (8) est réalisé à l'aide d'un outil (9) présentant un laser (91) ou une aiguille creuse (92).

7. Procédé selon l'une des revendications 1 à 6, **caractérisé en ce qu'**une matière visqueuse électriquement conductrice (70), en particulier une pâte ou une encre, est introduite dans l'évidement (8) pour produire l'élément de contact (7).
